# EUROPÄISCHE PATENTSCHRIFT

(11) **EP 1 701 605 B1**
(45) Veröffentlichungstag und Bekanntmachung des Hinweises auf die Patenterteilung: **27.02.2008**
(21) Anmeldenummer: 05005343.8
(22) Anmeldetag: 11.03.2005
(51) Int. Cl.: H05K 9/00

(54) **HF-Dichtungsstreifen**
EMI shielding gasket
Joint d'étanchéite de protection contre les intéférences électromagnétiques

(43) Veröffentlichungstag der Anmeldung: 13.09.2006
(73) Patentinhaber: Schroff GmbH, D-75334 Straubenhardt (DE); MTC Micro Tech Components GmbH, 89407 Dillingen (DE)
(72) Erfinder: Rutherford, Paul, 76228 Karlsruhe (DE); Joist, Michael, 76571 Gaggenau (DE); Dratwa, Peter, 89440 Unterliezheim (DE)
(74) Vertreter: Durm, Frank

(56) Entgegenhaltungen:
- EP-A- 1 052 887
- US-A1- 2003 051 891
- US-B1- 6 483 023

## Beschreibung

Die Erfindung betrifft einen HF-Dichtungsstreifen für elektromagnetisch abgeschirmte einschiebbare Elektronikmodule, mit einem Kern aus wenigstens teilweise elastisch verformbarem Material, einer den Kern einschließenden Hülle aus flexiblem, eine elektrische Verbindung zwischen benachbarten Elektronikmodulen bzw. einem die Elektronikmodule aufnehmenden Gehäuse und einem Elektronikmodul herstellenden leitfähigen Werkstoff, insbesondere einem Vlies oder einem Textilgewebe, und einer Auflagefläche, die von einem Abschnitt der Hülle gebildet wird.

In Modulweise aufgebaute elektronische Geräte bestehen aus einzelnen Steckbaugruppen oder Elektronikmodulen, die in einen Baugruppenträger oder ein Gehäuse eingesetzt werden. Die einzelnen Elektronikmodule sind ein- und ausschiebbar ausgeführt, um leicht montiert bzw. ausgetauscht werden zu können. Das Einschieben oder Herausziehen erfolgt dabei senkrecht zur Front des Elektronikmoduls in der Tiefenrichtung. Die seitliche Führung erfolgt durch im Baugruppenträger bzw. Gehäuse montierte Führungsschienen.

In eingeschobenem Zustand verschließt die Frontplatte des Elektronikmoduls die Front des Baugruppenträgers oder Gehäuses. Die Frontplatte hat oft U-förmigen Querschnitt, bei dem zwei seitliche Schenkel rechtwinklig von der Frontplatte nach hinten abstehen und in das Innere des Gehäuses oder Baugruppenträgers hineinragen. Diese nach hinten ragenden Schenkel dienen als Kontaktfläche zur Herstellung einer elektrisch leitenden Verbindung mit den benachbarten Elektronikmodulen oder anderen Gehäuseteilen. Auf diese Weise wird eine gute Abschirmung gegen das Eindringen bzw. Austreten hochfrequenter elektromagnetischer Strahlung (HF-Strahlung) bewirkt. Es gibt auch Frontplatten mit, an allen vier Kanten nach hinten abgebogenen Schenkeln.

Um die unvermeidlichen Spalte zwischen benachbarten Elektronikmodulen HFdicht zu verschließen, werden spezielle Kontaktierungselemente eingesetzt, beispielsweise in Form von Metallkontaktstreifen mit Federelementen oder zusammenpressbaren Dichtungen aus leitfähigem textilem Material.

Weiche HF-Dichtungsstreifen aus Textil haben mehrere Vorteile: Die Montage erfolgt einfach durch Aufkleben auf eine ebene Dichtungsfläche, beispielsweise mittels Klebestreifen, wozu es keines Werkzeugs oder besonderen Geschicks bedarf. Endlosstreifen aus textilem Material sind relativ kostengünstig herzustellen und lassen sich vor Ort auf die gewünschte Länge schneiden. Im Vergleich zu scharfkantigen Federelementen sind Textildichtungen unproblematisch in der Handhabung und können weder Verletzungen bei Personen noch Beschädigungen an den mechanischen und elektronischen Bauteilen verursachen.

Bekannt sind EMC-Profildichtungen mit einem Kern aus Schaumstoff und einem Textilmantel mit Kupfer-Nickel-Beschichtung. Diese Profildichtungen haben eine ebene Auflagefläche, mit der sie auf eine Frontplatte aufgeklebt werden, und einen von der Auflagefläche abstehenden gewölbten Wulst

Das Dokument EP 1 052 887 A2 zeigt in Figur 6 einen Dichtungsstreifen, der aus einem Kern aus Schaumstoff und einer Hülle aus leitfähigem Gewebe besteht. Im Bereich des einen Randes bildet das Gewebe der Hülle eine im Querschnitt U-förmige Lasche. Der Kern aus Schaumstoff ist relativ dick im Vergleich zu der Stärke des Gewebes der Hülle, auch im Bereich der Ränder.

Die Textildichtung der Firma Chomerics, Serie 7000 Profil 74095, besteht ebenfalls aus einem Schaumkern und einer diesen umgebenden Hülle aus mit Nickel-Kupfer beschichtetem Polyestergewebe. Der elastisch verformbare Schaumkern wird zu den Rändern der Dichtung hin dünner; die Ränder selbst sind rundlich.

Diese bekannte Profildichtung zeigt einen symmetrischen Querschnitt, der einer Sinus-Welle ähnelt, wobei die Dichtung bereits am Rand über 1 mm dick ist bei einer Gesamtdicke von etwa 3 mm.

Solange Textildichtungen nur senkrecht zu ihrer Klebefläche gepresst werden, erfüllen sie alle Anforderungen an eine gute dauerhafte HF-Dichtung. Problematisch hingegen ist eine Belastung durch Schubkräfte, die seitlich auf die Dichtung einwirken, also parallel zur Klebefläche. Werden textile Dichtungsstreifen zwischen zwei gegenüberliegenden Seiten von benachbarten, ein- und ausschiebbaren Elektronikmodulen eingesetzt, so besteht die Gefahr, dass der nachgiebige Dichtungsstreifen insbesondere beim Einschieben der Module von der Klebefläche abgeschält wird oder der Dichtungswulst übermäßig verformt wird. Vor allem geschnittene Kanten von Frontplatten oder scharf ausgebildete Ecken können Dichtungsstreifen aus textilem Material schnell beschädigen oder gar zerstören oder vom Untergrund abreißen.

In jüngster Zeit wurden Forderungen nach besonders dünnen Textildichtungen, die parallel zur Klebefläche auf Schub belastbar sind, laut. So fordert der für Telekommunikationsanwendungen von der PICMG (PCI Industrial Computing Manufacture Group) entwickelte AMC-Standard (Advanced Mezzanine Card Specification) eine HF-Dichtung, die in unbelastetem Zustand nur etwas über 2 mm dick ist.

Der Erfindung liegt also das technische Problem zugrunde, einen HF-Dichtungsstreifen aus textilem Material so zu gestalten, dass er eine reduzierte Dicke hat und in besonders schmale Spalten zwischen zwei Elektronikmodulen eingesetzt werden kann, gleichzeitig aber möglichst widerstandsfähig ist, besonders gegen quer zur Auflagefläche eingeleitete Schubkräfte beim Ein- oder Ausschieben eines Elektronikmoduls.

Bei der Lösung des Problems wird ausgegangen von einem HF-Dichtungsstreifen der eingangs erwähnten Art, also mit einem wenigstens teilweise verformbaren Kern und einer Hülle aus einem flexiblen, elektrisch leitfähigen Werkstoff, wobei ein Abschnitt der Hülle eine Auflagefläche bildet. Gelöst wird die Aufgabe dadurch, dass die Hülle wenigstens im Bereich des einschubseitigen Randes der Auflagefläche eine doppellagige Lasche bildet, in welcher zwei Lagen des Werkstoffs der Hülle Seite auf Seite unmittelbar aneinander liegen. Die doppellagige Lasche am Rand kann einfach durch Umschlagen des Textilgewebes um 180° erreicht werden.

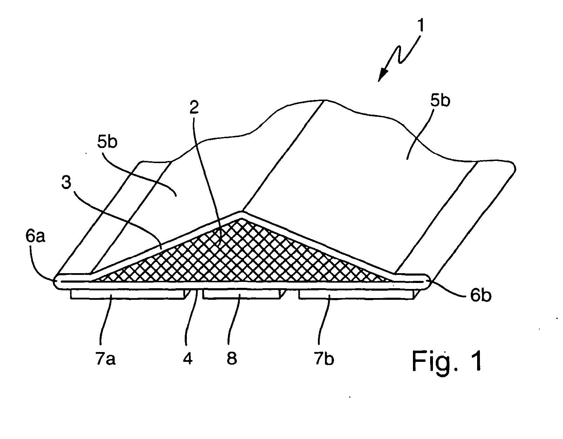

Die US 2003/005 1891 A1 zeigt in Fig. 1A eine Dichtung aus einem mit metallisiertem Gewebe kaschierten Polymer-Kunststoff, umfassend eine ebene Basis und gebogene Zungen. Fig. 1C zeigt das Profil, das an seiner Oberseite das metallisierte Gewebe trägt. Am linken Ende bildet das Gewebe eine Lasche um das Profil. Das Gewebe liegt aber nicht Seite auf Seite aneinander.

Die US 6 483 023 B1 betrifft HF-Dichtungen, bei denen ein Gewebe über eine metallene Feder gezogen wird. Fig. 5B zeigt eine solche Feder in der Art eines Kamms. Fig. 5A zeigt das Profil eines einzelnen Zinkens, Fig. 5C eine Hülle aus metallischem Gewebe und Fig. 5D einen Querschnitt durch die Hülle mit eingelegter Feder. Auch bei dieser HF-Dichtung liegen nicht zwei Lagen des Werkstoffs der Hülle im Bereich des Randes unmittelbar Seite auf Seite aufeinander, also ohne einen anderen Werkstoff dazwischen.

In der Regel besteht der Kern als ganzes aus einem verformbaren elastischen Material wie beispielsweise Schaum. Es ist jedoch nicht ausgeschlossen, den Kern nur teilweise aus einem plastisch verformbaren Material herzustellen und in den Kern einen ihn verfestigenden Körper, beispielsweise einen Draht, einzubringen.

Als elektrisch leitfähiger Werkstoff eignet sich beispielsweise ein Vlies, ein Gewebe, insbesondere ein Textilgewebe, oder ein sonstiges flächenförmiges Material.

Erfindungsgemäß reicht das elastisch verformbare Material des Kerns nicht bis ganz an die Ränder des HF-Dichtungsstreifens, sondern endet schon ein Stück davor, nämlich vor der wenigstens einen Lasche aus doppellagigem Werkstoff. Dadurch können auch die Ränder sehr dünn ausgeführt werden, bei gleichzeitig maximaler Festigkeit durch die zwei sich gegenseitig verstärkenden Lagen des Werkstoffs. Die Dicke der Randzonen entspricht somit minimal dem Zweifachen der Dicke des Werkstoffs, aus dem die Hülle besteht, und ist damit erheblich dünner als bei herkömmlichen Textildichtungen. Es bleibt somit mehr Höhe für den Dichtungswulst bei unverändertem Verhältnis zwischen der Dicke der HF-Dichtung in unbelastetem und der Dicke in zusammengepresstem Zustand. Ein besonderer Vorteil ist zudem, dass selbst bei ungünstigen Toleranzen beim Einschieben eines Elektronikmoduls dessen quer zur Auflagefläche bewegte Kante über die Lasche aus doppellagigem Werkstoff hinweggeht und erst anschließend in den Bereich des Kerns vorstößt, indem der Elektronikmodul auf eine Seite des Dichtungsstreifens, d.h. auf den die Außenseite bildenden Werkstoff, aufläuft. Gerade bei engen Spaltmaßen kann so beim Einschieben eines Elektronikmoduls ein sehr leichtes Ansetzen bzw. Auflaufen der HF-Dichtung erreicht werden.

Bevorzugt weist der Dichtungsstreifen an beiden Seiten eine doppellagige Lasche auf, um sowohl beim Einschieben als auch beim Herausziehen eines Elektronikmoduls eine leichte Bewegung zu erlauben.

Die beiden Lagen des Textilgewebes, welche die Laschen im Bereich der Ränder bilden, sind bevorzugt aufeinandergeklebt oder zusammengeschweißt. Wird der Kleber in flüssiger Form aufgebracht, beispielsweise als Heißkleber oder ZweiKomponenten-Kleber, so dringt dieser in die Hohlräume zwischen den Fasern des Textilgewebes und führt nach dem Erkalten bzw. Abbinden zu einer zusätzlichen Versteifung und Stabilisierung der Struktur.

Der Kern aus elastisch verformbarem Material hat bevorzugt einen Querschnitt in Form eines nicht-gleichseitigen Dreiecks, wobei die kurzen Seiten des Dreiecks die schrägen Auflaufflächen des Dichtungswulstes und die lange Seite gegenüber dem in der Zeichnung oben dargestellten Winkel die ebene Auflagefläche definieren. Als zweckmäßig hat sich ein Winkel zwischen 80° und 160° erwiesen, was eine relativ flache dachförmige Dichtung ergibt. Bevorzugt beträgt der Winkel um 140°. Bei einer solchen dreieckigen Querschnittsform werden durch geringstmögliche Materialverlagerung bzw. Umformung während des Ein- oder Ausschiebens unnötige Kräfte vermieden. Die im Wesentlichen ebene Ausbildung der mäßig schrägen Auflaufflächen verhindert eine allzu starke Wulstausbildung beim Auftreffen und Schieben der Kante eines Elektronikmoduls quer zur Auflagefläche. Die in Folge der Laschenbildung besonders stabilen und steifen Randbereiche des erfindungsgemäßen HF-Dichtungsstreifens stützen die schrägen Auflaufflächen ab und halten diese straff.

Als Material für den Kern hat sich aufgeschäumter Kunststoff, beispielsweise Polyurethan-Schaum bewährt. Das Textilgewebe für die Hülle besteht beispielsweise aus Polyester-Fasern, die durch eine Metallisierung oder durch eine Beschichtung mit Nickel- und Kupferschichten leitfähig gemacht wurden. Es versteht sich, dass in an sich bekannter Weise eine Vielzahl von Metallen für die Metallisierung oder für die Beschichtung zum Einsatz kommen kann, beispielsweise auch Silber oder Gold.

Die Befestigung des HF-Dichtungsstreifens auf der Dichtungsfläche eines Elektronikmoduls geschieht am besten mittels Klebestreifen, die an der Auflagefläche des Dichtungsstreifens angebracht sind. Eine besonders gute Haftung auf dem Untergrund wird erzielt, wenn je ein Klebestreifen im Bereich jeder Lasche angeordnet ist. Der Mittelbereich der Auflagefläche kann frei bleiben, um eine einwandfreie Kontaktierung mit der metallenen Dichtungsfläche des Elektronikmoduls zu gewährleisten. Dadurch, dass der HF-Dichtungsstreifen einen wenigstens im Wesentlichen elastischen Kern aufweist, wird der HF-Dichtungsstreifen im eingeschobenen Zustand zusammengedrückt, was dazu führt, dass die Auflagefläche sich in Richtung zu dem Elektronikmodul, auf dem sie aufliegt, durchbiegt und dadurch wenigstens in der Mitte fest auf dem Elektronikmodul aufliegt. Da die äußeren Ränder der Laschen recht scharfkantig ausgebildet sind, können die Klebestreifen bis unmittelbar an die Ränder der Auflagefläche heranreichen. Dies ergibt eine besonders hohe Standfestigkeit gegen Ablösen der Dichtung vom Untergrund.

In vorteilhafter und zweckmäßiger Weiterbildung der Erfindung können insgesamt drei parallele Dichtungsstreifen auf der Auflagefläche angebracht werden, wobei der mittlere Klebestreifen aus leitfähigem Material ist. Dieser mittlere leitfähige Klebestreifen stellt dann den elektrischen Kontakt zwischen dem HF-Dichtungsstreifen und der Dichtungsfläche des Elektronikmoduls her, wohingegen die beiden Klebestreifen an der Seite maximale Haftkraft haben. Technologiebedingt hat ein nicht leitender Kleber mehr Klebekraft als ein elektrisch leitender Kleber. Durch Kombination von leitenden und nicht leitenden Klebestreifen lässt sich also die Gesamtklebekraft an der Auflagefläche erheblich erhöhen im Vergleich zur Verwendung von nur zwei äußeren Klebestreifen unter Aussparung eines freien Bereichs in der Mitte.

Ein Ausführungsbeispiel der Erfindung wird nachstehend anhand der beigefügten Zeichnungen näher erläutert. Es zeigen:
- Fig. 1: einen HF-Dichtungsstreifen in vergrößerter perspektivischer Ansicht von vorne;
- Fig. 2a: den Einsatz eines HF-Dichtungsstreifens gemäß Fig. 1 in einen Spalt zwischen zwei Elektronikmodulen, wobei das untere Elektronikmodul gerade eingeschoben wird, in vereinfachter Darstellung;
- Fig. 2b: die Konfiguration von Fig. 2a mit vollständig eingeschobenem unterem Elektronikmodul und zusammengepressten HF-Dichtungsstreifen;
- Fig. 3: eine weitere Ausgestaltung eines HF-Dichtungsstreifens in einer vergrößerten Vorderansicht.

Der in Fig. 1 dargestellte HF-Dichtungsstreifen 1 besteht im Wesentlichen aus einem elastisch verformbaren Kern 2 und einer Hülle 3 aus flexiblem, metallisierten Textilgewebe. Als Material für den Kern 2 wird ein Kunststoffschaum, beispielsweise Polyurethan-Schaum verwendet. Die Hülle 3, die beispielsweise auch nahtlos sein kann, ist aus einem Polyester-Gewebe gefertigt. Zur Erzielung einer ausreichenden elektrischen Leitfähigkeit ist das Gewebe mit Schichten aus Nickel und Kupfer metallisiert oder beschichtet. Das Textilgewebe der Hülle 3 hat dadurch eine Abschirmwirkung von beispielsweise 60 - 70 dB für elektromagnetische Wellen bis in den Bereich von 2 GHz.

Der plastische Kern 2 hat einen Querschnitt in Form eines gleichschenkligen Dreiecks, wobei der obere Winkel ungefähr 140° beträgt. Auch der Querschnitt der Hülle 3 ist im Prinzip dreieckig, wobei der gegenüber dem oberen Winkel liegende Abschnitt eine ebene Auflagefläche bildet. Die den anderen Seiten des Dreiecks entsprechenden Abschnitte bilden schräge ebene Auflaufflächen 5a, 5b. Im Bereich des rechten und des linken Randes der Auflagefläche 4 ist das Textilgewebe der Hülle 3 um 180° umgeschlagen und bildet horizontal nach außen abstehende Laschen 6a, 6b. Im Bereich dieser Laschen 6a bzw. 6b sind zwei Lagen des Textilgewebes aufeinandergeklebt. Die Laschen 6a und 6b bilden dadurch schmale dünne Randstreifen des HF-Dichtungsstreifens, deren Unterseiten die ebene Auflagefläche 4 fortsetzen.

Auf der Auflagefläche 4 sind zwei parallele äußere Klebestreifen aufgebracht, die bis in den Bereich der Laschen 6a, 6b reichen und ganz knapp vor deren äußeren Rändern enden. Zwischen den Klebestreifen 7a, 7b ist ein weiterer mittlerer Klebestreifen 8 aus leitfähigem Material angeordnet.

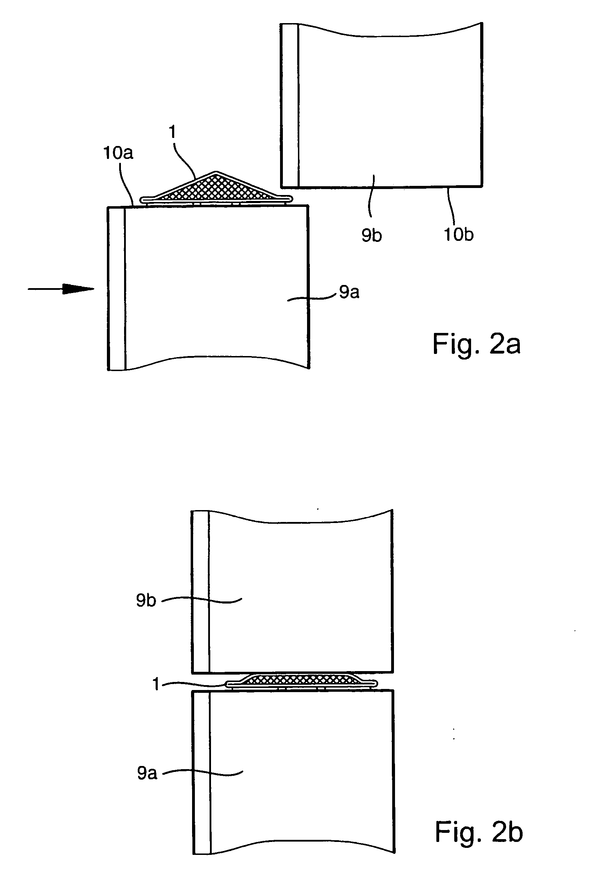

In der Konfiguration gemäß den Figuren 2a und 2b sind zwei elektromagnetisch abgeschirmte Elektronikmodule 9a und 9b übereinander angeordnet.

In Fig. 2a wird das untere Elektronikmodul 9a gerade in horizontaler Richtung von links nach rechts eingeschoben, während sich das darüber angeordnete Elektronikmodul 9b in eingeschobener Position befindet. Das Elektronikmodul 9a hat an seiner Oberseite eine ebene Dichtungsfläche 10a, dem eine korrespondierende Dichtungsfläche 10b an der Unterseite des oberen Elektronikmoduls 9b gegenüber steht.

Auf der Dichtungsfläche 10a des unteren Elektronikmoduls 9a ist ein HF-Dichtungsstreifen 1 der zuvor beschriebenen Art aufgeklebt. Dieser Dichtungsstreifen hat eine Breite von beispielsweise 10 mm und eine Höhe von beispielsweise 2,3 mm in unbelastetem Zustand. Der abzudichtende Spalt zwischen den benachbarten Elektronikmodulen 9a und 9b beträgt ca. 1 mm. Das untere Elektronikmodul 9a ist bereits soweit eingeschoben, dass die vordere untere Ecke des oberen Elektronikmoduls 9b unmittelbar vor dem HF-Dichtungsstreifen 1 steht.

In Fig. 2b ist das untere Elektronikmodul 9a vollständig eingeschoben, so dass es mit dem darüber befindlichen Elektronikmodul 9b fluchtet. Der HF-Dichtungsstreifen 1 ist zusammengespresst, wodurch sich seine Höhe auf das Maß des Spaltes zwischen den beiden Elektronikmodulen 9a und 9b, auf rund 1 mm, reduziert hat. Der Spalt zwischen den beiden Elektronikmodulen 9a und 9b ist dadurch abgedichtet, wobei gleichzeitig eine elektrisch leitende Verbindung über den HF-Dichtungsstreifen 1 hergestellt wurde.

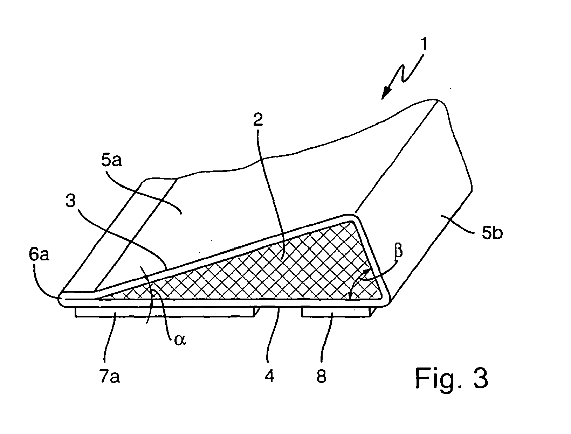

In einem weiteren Ausführungsbeispiel (Fig. 3) ist vorgegeben, dass der HF-Dichtungsstreifen 1 lediglich eine einschubseitige Lasche 6a aufweist. Ebenso hat der HF-Dichtungsstreifen 1 einen spitzen Winkel α zwischen der Auflagefläche 4 und der Auflauffläche 5a, der bevorzugt zwischen 5° und 30° liegt, aber auch größer sein kann. Auf der Seite, von der der HF-Dichtungsstreifen 1 aus den Elektronikmodulen herausgezogen wird, ist beispielsweise ein Winkel β vorhanden, der viel größer ist als der Winkel α und beispielsweise bis zu 90° beträgt. In diesem Ausführungsbeispiel bildet die Fläche 5b keine Auflauffläche.

### Zusammenstellung der Bezugszeichen

- 1: HF-Dichtungsstreifen
- 2: Kern
- 3: Hülle
- 4: Auflagefläche
- 5a, 5b: Auflaufflächen
- 6a, 6b: Laschen
- 7a, 7b: äußere Klebestreifen (an 4)
- 8: mittlerer Klebestreifen (an 4)
- 9a, 9b: Elektronikmodule
- 10a, 10b: Dichtungsflächen (von 9a, 9b)

## Patentansprüche

1. HF-Dichtungsstreifen für elektromagnetisch abgeschirmte einschiebbare Elektronikmodule, mit
- einem Kern (2) aus wenigstens teilweise elastisch verformbarem Material;
- einer den Kern (2) einschließenden Hülle (3) aus flexiblem, eine elektrische Verbindung zwischen benachbarten Elektronikmodulen bzw. einem die Elektronikmodule aufnehmenden Gehäuse und einem Elektronikmodul herstellenden leitfähigen Werkstoff, insbesondere einem Vlies oder einem Textilgewebe;
- einer Auflagefläche (4), die von einem Abschnitt der Hülle (3) gebildet wird; **dadurch gekennzeichnet, dass** die Hülle (3) wenigstens im Bereich des einschubseitigen Randes der Auflagefläche (4) eine doppellagige Lasche (6a, 6b) bildet, in welcher zwei Lagen des Werkstoffs der Hülle (3) Seite auf Seite unmittelbar aneinander liegen.

2. HF-Dichtung nach Anspruch 1, **dadurch gekennzeichnet, dass** im Bereich der wenigstens einen einschubseitigen Lasche (6a, 6b) die beiden Lagen des Werkstoffs aufeinandergeklebt oder zusammengeschweißt sind.

3. HF-Dichtung nach Anspruch 1 oder 2 **dadurch gekennzeichnet, dass** der Kern (2) einen Querschnitt in Form eines nicht gleich-seitigen Dreiecks hat, wobei wenigstens eine der kurzen Seiten eine schräge Auflauffläche (5a, 5b) und die lange Seite die Auflagefläche (4) definieren.

4. HF-Dichtung nach Anspruch 3, **dadurch gekennzeichnet, dass** die einschubseitige Auflauffläche (5a) mit der Auflagefläche (4) einen spitzen Winkel von höchstens 45°, insbesondere von weniger als 30°, bildet.

5. HF-Dichtung nach einem der Ansprüche 1 bis 4, **dadurch gekennzeichnet, dass** der Kern (2) einen Querschnitt in Form eines gleichschenkligen Dreiecks hat.

6. HF-Dichtung nach Anspruch 5, **dadurch gekennzeichnet, dass** der der Auflagefläche (4) gegenüberliegende Winkel zwischen 80° und 160°, vorzugsweise ungefähr 140° beträgt.

7. HF-Dichtung nach einem der Ansprüche 1 bis 6, **dadurch gekennzeichnet, dass** der Kern (2) aus aufgeschäumtem Kunststoff besteht.

8. HF-Dichtung nach einem der Ansprüche 1 bis 7, **dadurch gekennzeichnet, dass** die Hülle (3) metallisiert ist.

9. HF-Dichtung nach einem der Ansprüche 1 bis 8, **dadurch gekennzeichnet, dass** auf der Auflagefläche (4) mindestens ein Klebestreifen (7a, 7b, 8) angebracht ist.

10. HF-Dichtung nach Anspruch 9, **dadurch gekennzeichnet, dass** der Klebestreifen (7a) im Bereich der wenigstens einen Lasche (6a) angeordnet ist bzw. dass unter den Laschen (6a, 6b) jeweils ein Klebestreifen (7a, 7b) angeordnet ist.

11. HF-Dichtung nach Anspruch 9 oder 10, **dadurch gekennzeichnet, dass** zwischen den beiden äußeren Klebestreifen (7a, 7b) ein mittlerer Klebestreifen (8) aus leitfähigem Material angeordnet ist.

## Claims

1. An HF sealing strip for electromagnetically shielded insertable electronic modules, with
- a core (2) of an at least partially elastic moldable material;
- a covering (3) enclosing the core (2) out of a flexible, conducting working material, particularly of a non-woven material or a textile fabric, producing an electrical connection between adjacent electronic modules, or between the electronic module and the casing receiving the electronic module;
- a contact surface (4), which is formed from a section of the covering (3); **characterised in that** the covering (3), at least in the region of insertion-side edge of the contact surface (4), forms a double-layered tab (6a, 6b), in which two layers of the working material of the covering (3) lie side on side directly on top of each other.

2. An HF sealing strip according to claim 1, **characterised in that** in the region of the at least one insertion-side tab (6a, 6b) the two layers of the working material are bonded on top of each other or welded together.

3. An HF sealing strip according to claim 1 or 2, **characterised in that** the core (2) has a cross-section in the shape of a non-equilateral triangle, in which at least one of the short sides defines a slanted impact surface (5a, 5b) and the long side defines the contact surface (4).

4. An HF sealing strip according to claim 3, **characterised in that** the insertion-side impact surface (5a) forms with the contact surface (4) an acute angle of at most 45°, especially, of less than 30°.

5. An HF seal according to one of claims 1 through 4, **characterised in that** the core (2) has a cross-section in the shape of an isosceles triangle.

6. An HF sealing strip according to claim 5, **characterised in that** the angle lying opposite from the contact surface (4) amounts to between 80° and 160°, preferably approximately 140°.

7. An HF sealing strip according to one of claims 1 through 6, **characterised in that** the core (2) is composed of a foam synthetic material.

8. An HF sealing strip according to one of claims 1 through 7, **characterised in that** the covering (3) is metallised.

9. An HF sealing strip according to one of claims 1 through 8, **characterised in that** at least one adhesive strip (7a, 7b, 8) is applied on the contact surface (4).

10. An HF sealing strip according to claim 9, **characterised in that** at the adhesive strip (7a) is arranged in the region of at least one tab (6a), or that, in each case, an adhesive strip (7a, 7b) is arranged under the tabs (6a, 6b).

11. An HF sealing strip according to claims 9 or 10, **characterised in that** a middle adhesive strip (8) of conducting material is arranged in between the two outer adhesive strips (7a, 7b).

## Revendications

1. Joint d'étanchéité HF pour modules électroniques enfichables munis d'un blindage électromagnétique, comprenant
- un coeur (2) en une matière au moins en partie déformable élastiquement ;
- une gaine (3), renfermant le coeur (2), en un matériau conducteur flexible, en particulier un non-tissé ou un tissu textile, qui crée une liaison électrique entre des modules électroniques voisins ou entre un boîtier recevant les modules électroniques et un module électronique ;
- une surface d'appui (4) qui est formée par une section de la gaine (3) ;
**caractérisé en ce que** la gaine (3) forme au moins dans la zone de la bordure, du côté enfichage, de la surface d'appui (4) une patte bicouche (6a, 6b), dans laquelle deux couches du matériau de la gaine (3) se situent directement l'une sur l'autre côté sur côté.

2. Joint HF suivant la revendication 1, **caractérisé en ce que**, dans la zone de la au moins une patte (6a, 6b) du côté enfichage, les deux couches du matériau sont collées l'une sur l'autre ou soudées entre elles.

3. Joint HF suivant l'une des revendications 1 et 2, **caractérisé en ce que** le coeur (2) a une section transversale en forme d'un triangle non équilatéral, au moins l'un des petits côtés définissant une surface de contact oblique (5a, 5b) et le grand côté définissant la surface d'appui (4).

4. Joint HF suivant la revendication 3, **caractérisé en ce que** la surface de contact (5a) du côté enfichage forme avec la surface d'appui (4) un angle aigu de 45° au maximum, en particulier de moins de 30°.

5. Joint HF suivant l'une des revendications 1 à 4, **caractérisé en ce que** le coeur (2) a une section transversale en forme d'un triangle isocèle.

6. Joint HF suivant la revendication 5, **caractérisé en ce que** l'angle en vis-à-vis de la surface d'appui (4) est compris entre 80° et 160°, est de préférence d'environ 140°.

7. Joint HF suivant l'une des revendications 1 à 6, **caractérisé en ce que** le coeur (2) est constitué de matière plastique expansée.

8. Joint HF suivant l'une des revendications 1 à 7, **caractérisé en ce que** la gaine (3) est métallisée.

9. Joint HF suivant l'une des revendications 1 à 8, **caractérisé en ce qu'**au moins un ruban adhésif (7a, 7b, 8) est appliqué sur la surface d'appui (4).

10. Joint HF suivant la revendication 9, **caractérisé en ce que** le ruban adhésif (7a) est disposé dans la zone de la au moins une patte (6a) ou qu'un ruban adhésif (7a, 7b) est respectivement disposé au-dessous des pattes (6a, 6b).

11. Joint HF suivant l'une des revendications 9 et 10, **caractérisé en ce qu'**un ruban adhésif central (8) en matière conductrice est disposé entre les deux rubans adhésifs extérieurs (7a, 7b).
